(19) Europäisches Patentamt
European Patent Office
Office européen des brevets

(11) **EP 2 947 427 B1**

(12) **EUROPÄISCHE PATENTSCHRIFT**

(45) Veröffentlichungstag und Bekanntmachung des Hinweises auf die Patenterteilung:
**09.08.2023 Patentblatt 2023/32**

(21) Anmeldenummer: **14004207.8**

(22) Anmeldetag: **13.12.2014**

(51) Internationale Patentklassifikation (IPC):
**G01F 1/58** (2006.01)   **G01R 33/563** (2006.01)
**G01R 33/561** (2006.01)   **G01R 33/44** (2006.01)
**G01N 24/08** (2006.01)   **G01F 1/716** (2006.01)

(52) Gemeinsame Patentklassifikation (CPC):
**G01F 1/716; G01R 33/56308;** G01N 24/081

(54) **KERNMAGNETISCHES DURCHFLUSSMESSGERÄT UND VERFAHREN ZUM BETREIBEN EINES KERNMAGNETISCHEN DURCHFLUSSMESSGERÄTS**

NUCLEAR MAGNETIC FLOW MEASUREMENT DEVICE AND METHOD FOR OPERATING A NUCLEAR MAGNETIC RESONANCE FLOW MEASUREMENT DEVICE

APPAREIL DE MESURE DE DÉBIT À NOYAU MAGNÉTIQUE ET PROCÉDÉ DE FONCTIONNEMENT D'UN APPAREIL DE MESURE DE DÉBIT À NOYAU MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.05.2014 DE 102014007509**
**14.07.2014 DE 102014010324**

(43) Veröffentlichungstag der Anmeldung:
**25.11.2015 Patentblatt 2015/48**

(73) Patentinhaber: **Krohne AG**
**4019 Basel (CH)**

(72) Erfinder:
• **Hogendoorn, Cornelis Johannes**
**NL 4211 BG Sijk (NL)**
• **Zoeteweij, Marco Leendert**
**NL 3344 EP Hendrik-Ido-Ambach (NL)**
• **Bousché, Olaf Jean Paul**
**NL 3319 PH Dordrecht (NL)**
• **Tromp, Rutger Reinout**
**NL 3311 EM Dordrecht (NL)**
• **Cerioni, Lucas Matias Ceferino**
**NL 3311 GN Dordrecht (NL)**

(74) Vertreter: **Gesthuysen Patentanwälte Partnerschaftsgesellschaft mbB**
**Huyssenallee 68**
**45128 Essen (DE)**

(56) Entgegenhaltungen:
**EP-A2- 0 287 146       DE-A1-102004 043 151**
**US-A1- 2012 092 007**

**Beschreibung**

Die Erfindung betrifft ein Verfahren zum Betreiben eines kernmagnetischen Durchflussmessgerätes. Ein kernmagnetisches Durchflussmessgerät dient der Bestimmung des Durchflusses eines durch ein Messrohr strömenden Mediums. Dazu ist es mit einer aus Permanentmagneten bestehenden Magnetfelderzeugungseinrichtung zur Erzeugung eines das Medium durchsetzenden Magnetfeldes über eine Magnetfeldstrecke $L_M$, mit einer innerhalb der Magnetfeldstrecke $L_M$ liegenden Vormagnetisierungsstrecke $L_{VM}$ und mit einer eine als Messantenne dienende, spulenförmig ausgebildete Antenne der Länge $L_1$ umfassenden, ebenfalls in der Magnetfeldstrecke $L_M$ liegenden Messeinrichtung ausgestattet.

Die Atomkerne der Elemente, die einen Kernspin besitzen, besitzen auch ein durch den Kernspin hervorgerufenes magnetisches Moment. Der Kernspin kann als ein durch einen Vektor beschreibbarer Drehimpuls aufgefasst werden, und entsprechend kann auch das magnetische Moment durch einen Vektor beschrieben werden, der parallel zum Vektor des Drehimpulses ist. Der Vektor des magnetischen Moments eines Atomkerns richtet sich bei Anwesenheit eines makroskopischen Magnetfelds parallel zu dem Vektor des makroskopischen Magnetfelds an der Stelle des Atomkerns aus. Dabei präzediert der Vektor des magnetischen Moments des Atomkerns um den Vektor des makroskopischen Magnetfelds an der Stelle des Atomkerns. Die Frequenz der Präzession wird als Lamorfrequenz $\omega_L$ bezeichnet und ist dem Betrag der Magnetfeldstärke *B* proportional. Die Lamorfrequenz wird gemäß $\omega_L = \gamma \cdot B$ berechnet. Darin ist $\gamma$ das gyromagnetische Verhältnis, welches für Wasserstoffatome maximal ist. Das gyromagnetische Verhältnis gibt den Proportionalitätsfaktor zwischen dem Drehimpuls bzw. dem Spin eines Teilchens und dem dazugehörigen magnetischen Moment an.

Mess- und Analyseverfahren, die die Eigenschaft der Präzession von Atomkernen mit einem magnetischen Moment bei Anwesenheit eines makroskopischen Magnetfelds ausnutzen, werden als kernmagnetische Resonanz-Mess- oder -Analyseverfahren bezeichnet. Der englische Begriff für kernmagnetische Resonanz ist *Nuclear Magnetic Resonance* (NMR).

Voraussetzung für eine Analyse eines mehrphasigen Mediums unter Ausnutzung kernmagnetischer Resonanz ist, dass die zu analysierenden Phasen des Mediums zu unterscheidbaren kernmagnetischen Resonanzen angeregt werden können. Die Analyse kann die Strömungsgeschwindigkeiten der einzelnen Phasen des Mediums und die relativen Anteile der einzelnen Phasen am mehrphasigen Medium umfassen. Kernmagnetische Durchflussmessgeräte können zum Beispiel zur Analyse des aus Ölquellen geförderten mehrphasigen Mediums eingesetzt werden. Das Medium besteht dann im Wesentlichen aus den Phasen Rohöl, Erdgas und Salzwasser, wobei alle Phasen Wasserstoffatomkerne enthalten.

Die Analyse des aus Ölquellen geförderten Mediums kann auch mit sogenannten Testseparatoren erfolgen. Diese zweigen einen kleinen Teil des geförderten Mediums ab, trennen die einzelnen Phasen des Mediums voneinander und bestimmen die Anteile der einzelnen Phasen an dem Medium. Jedoch sind Testseparatoren nicht im Stande, Rohölanteile kleiner als 5 % zuverlässig zu messen. Da der Rohölanteil einer jeden Quelle stetig sinkt und der Rohölanteil vieler Quellen bereits kleiner als 5 % ist, ist es derzeit nicht möglich, diese Quellen unter Verwendung von Testseparatoren wirtschaftlich auszubeuten. Um auch Quellen mit einem sehr geringen Rohölanteil weiterhin ausbeuten zu können, sind dementsprechend genaue Durchflussmessgeräte erforderlich.

Für gewöhnlich werden die von den präzedierenden Atomkernen nach Anregungen in einer Messantenne induzierten elektrischen Signale als Ausgangsgröße für die Auswertung verwendet. Voraussetzung für die Messung eines mehrphasigen Mediums ist, wie bereits ausgeführt, dass die einzelnen Phasen des Mediums zu unterscheidbaren kernmagnetischen Resonanzen angeregt werden können. Die Größe der von den präzedierenden Atomkernen einer Phase des Mediums in der Messantenne induzierten elektrischen Signale ist abhängig von der Anzahl der präzedierenden Atomkerne pro Volumenelement in dieser Phase, demnach also abhängig von der Dichte der Phase, aber auch von der Beeinflussungsdauer der Atomkerne im beeinflussenden Magnetfeld.

Folglich ist die Größe der induzierten elektrischen Signale unterschiedlich für die jeweiligen Phasen des Mediums.

Messverfahren zur Bestimmung der einzelnen Phasen am Medium sehen vor, dass das Medium für eine bestimmte Zeit t dem in der Vormagnetisierungsstrecke erzeugten Magnetfeld ausgesetzt ist und dann die Magnetisierung des Mediums in Richtung des Magnetfeldes nach verschieden langen Beeinflussungsdauern des in der Vormagnetisierungsstrecke erzeugten Magnetfelds auf das Medium bestimmt wird. Die Bestimmung der Magnetisierung des Mediums nach einer bestimmten Beeinflussungsdauer erfolgt in der Messeinrichtung durch Anregung des magnetisierten Mediums mit Anregungssignalen, Messung der von den Anregungssignalen im Medium hervorgerufenen Messsignale und Auswertung der Messsignale.

Aus dem Stand der Technik bekannte kernmagnetische Durchflussmessgeräte der eingangs beschriebenen Art variieren die wirksame Beeinflussungsdauer des Magnetfeldes auf das Medium durch eine Veränderung des Magnetfeldes, wobei die Veränderung des Magnetfeldes durch eine Mechanik bewirkt wird.

Aus der US 7,872,474 B2 ist ein kernmagnetisches Durchflussmessgerät der eingangs beschriebenen Art bekannt. Die Magnetfelderzeugungseinrichtung umfasst mehrere um das Messrohr angeordnete, entlang der Messrohrlängsachse aufeinanderfolgende Magnetanordnungen. Jede der Magnetanordnungen ist um die Messrohrlängsachse drehbar und durchsetzt das durch das Messrohr strömende Medium mit einem eine bestimmte Richtung aufweisenden Magnetfeld. Die effektive Vormagnetisierungsstrecke wird nun dadurch variiert, dass die jeweiligen Magnetfelder der einzelnen Magnetanordnungen parallel oder antiparallel zueinander ausgerichtet werden. Bei einer parallelen Ausrichtung zweier durch jeweils eine Magnetanordnung erzeugten Magnetfelder baut sich in dem Medium eine Magnetisierung über die Zeit auf, die es dauert, bis das Medium die beiden Magnetanordnungen durchflossen hat. Bei einer antiparallelen Ausrichtung zweier benachbarter Magnetfelder baut sich in der ersten Magnetanordnung eine Magnetisierung in dem Medium auf, die in der zweiten Magnetanordnung aufgrund der entgegengesetzten Feldrichtung wieder zerstört wird. Die effektive Vormagnetisierungsstrecke ist in dem Fall null.

Das Drehen der jeweiligen Magnetbaugruppen erfordert eine Mechanik. Diese Mechanik benötigt zum einen Platz und ist zum anderen mit Kosten verbunden. Außerdem unterliegen die sich mechanisch bewegenden Teile der Abnutzung und müssen in regelmäßigen Abständen gewartet werden. Das bedeutet sowohl zeitlichen als auch finanziellen Aufwand.

Ebenfalls aus dem Stand der Technik bekannt ist eine Vorrichtung zur Variation der Vormagnetisierungsstrecke, bei der mehrere Magnetanordnungen um ein Messrohr angeordnet sind. Jede dieser Magnetanordnungen besteht aus einem inneren, aus einem permanentmagnetischen Material bestehenden Ring und einem äußeren, ebenfalls aus einem permanentmagnetischen Material bestehenden Ring. Jeder dieser Ringe erzeugt ein eigenes Magnetfeld. Die beiden Ringe können relativ umeinander verschoben werden. Befinden sich die Ringe in einer derartigen Position zueinander, dass die beiden Magnetfelder parallel zueinander ausgerichtet sind, ist im Inneren der Magnetanordnung ein starkes Magnetfeld. Sind die beiden Ringe derart zueinander ausgerichtet, dass die beiden Magnetfelder antiparallel zueinander ausgerichtet sind, ist das Feld im Inneren der Magnetanordnung null. Durch die Anordnung mehrerer solcher Magnetanordnungen hintereinander lässt sich die effektive Vormagnetisierungsstrecke beliebig variieren.

Auch hier wird die Vormagnetisierungsstrecke durch eine Mechanik eingestellt, die die Ringe jeweils einer der Magnetanordnungen gegeneinander dreht. Dafür muss zum einen ein hoher Zeitaufwand in Kauf genommen werden, zum anderen benötigen die sich bewegenden Komponenten einer regelmäßigen Wartung, was mit Kosten und weiterem Zeitaufwand sowie Verschleiß verbunden ist.

Aus der US 2012/0092007 A1 ist ein weiteres kernmagnetisches Durchflussmessgerät bekannt. Das kernmagnetische Durchflussmessgerät weist ein Messrohr und eine Magnetfelderzeugungseinrichtung zur Erzeugung eines das Messrohr durchsetzenden Magnetfelds über eine Magnetfeldstrecke, eine innerhalb der Magnetfeldstrecke liegende Vormagnetisierungsstrecke und eine eine als Messantenne dienende, spulenförmig ausgebildete Antenne umfassende ebenfalls in der Magnetfeldstrecke liegende Messeinrichtung auf. Weiter ist ein Verfahren zur Schätzung einer Durchflussrate einer Phase des Mediums durch das Messrohr offenbart.

Bei dem kernmagnetischen Durchflussmessgerät der eingangs beschriebenen Art ist in der Vormagnetisierungsstrecke $L_{VM}$ mindestens eine spulenförmig ausgebildete Antenne zur Erzeugung eines die Magnetisierung des Mediums in Richtung des äußeren Magnetfeldes zerstörenden Pulses oder einer die Magnetisierung des Mediums in Richtung des äußeren Magnetfeldes zerstörenden Pulssequenz, im Folgenden zusammenfassend auch als Zerstörungspuls bezeichnet, vorgesehen. Die Antenne kann um das Messrohr, im Übrigen an einer beliebigen Stelle in der Vormagnetisierungsstrecke angeordnet sein. Der Puls kann in Strömungsrichtung des Mediums erzeugt werden. Im Folgenden soll die Strömungsrichtung des Mediums als x-Richtung bezeichnet werden, während das durch die Magnetfelderzeugungseinrichtung erzeugte Magnetfeld in z-Richtung senkrecht zu der Strömungsrichtung erzeugt wird.

Dadurch kann auf eine sehr einfache und wartungsfreie Art und Weise die Länge der effektiven Vormagnetisierungsstrecke variiert werden. Erzeugt die Antenne keinen Zerstörungspuls, entspricht die Vormagnetisierungsstrecke der gesamten Magnetfeldstrecke bis zur Messeinrichtung. Erzeugt die Antenne hingegen einen Zerstörungspuls, so wird die Magnetisierung im Bereich der Antenne zerstört, und sie baut sich danach über das verbleibende Stück zwischen Antenne und Messeinrichtung wieder neu auf, die effektive Vormagnetisierungsstrecke ist dadurch also verkürzt.

Der Aufbau der Magnetisierung nach dem Zerstörungspuls folgt der Gesetzmäßigkeit

$$M = M_0 \left( 1 - \exp\left( -\frac{L_{VM}}{vT_1} \right) \right)$$

Hierbei ist $L_{VM}$ die effektive Vormagnetisierungsstrecke, also die Strecke zwischen der den Zerstörungspuls aussendenden Antenne und der Antenne in der Messeinrichtung, v die Strömungsgeschwindigkeit des Mediums und $T_1$ die Spin-Gitter-Relaxationszeit des Mediums bzw. der einzelnen Phasen des Mediums.

Die Strömungsgeschwindigkeiten der einzelnen Phasen eines mehrphasigen Mediums müssen nicht identisch sein. In der Realität weisen die einzelnen Phasen eines Mediums oft unterschiedliche Strömungsgeschwindigkeiten auf, das Strömungsprofil weist also eine maximale Strömungsgeschwindigkeit $V_{max}$ und eine minimale Strömungsgeschwindigkeit $V_{min}$ auf. Unterschiedliche Strömungsgeschwindigkeiten können zu sogenanntem "phase slip" führen, dem "Überholen" einer langsamer strömenden Phase durch eine schneller strömende Phase. Dieser Effekt wirkt sich negativ auf die Durchflussmessungen aus, da bei einer durch Permanentmagneten erzeugten Vormagnetisierungsstrecke die Beeinflussungsdauer der einzelnen Phase und damit der Aufbau der Magnetisierung in Richtung des Magnetfeldes direkt mit der Strömungsgeschwindigkeit der Phase zusammenhängt. Eine schnell strömende Phase hat demnach eine kürzere Beeinflussungsdauer als eine langsam strömende Phase bei gleicher Vormagnetisierungsstrecke.

Die Antenne kann zur Erzeugung von Zerstörungspulsen in einem Abstand d zur Antenne der Messeinrichtung angeordnet sein und die Länge $L_2$ der den Zerstörungspuls erzeugenden Antenne kann derart gewählt werden, dass die Bedingung

$$L_2 \geq 2d\left(\frac{v_{max} - v_{min}}{v_{max} + v_{min}}\right) + L_1$$

erfüllt ist. Hierbei ist $V_{max}$ die maximale Strömungsgeschwindigkeit im Strömungsprofil, $V_{min}$ die minimale Strömungsgeschwindigkeit und $L_1$ die Länge der Antenne der Messeinrichtung. Hierdurch wird garantiert, dass das gesamte sich zum Zeitpunkt der Messung im Bereich der Messantenne befindliche Medium zuvor den Zerstörungspuls gespürt hat und sich die Magnetisierung jeder Phase unabhängig von der jeweiligen Strömungsgeschwindigkeit über die selbe Zeit aufgebaut hat, also jede Phase die selbe Beeinflussungsdauer des Magnetfeldes erfahren hat.

Für die Magnetisierung gilt

$$M = M_0\left(1 - \exp\left(-\frac{\Delta t}{T_1}\right)\right)$$

wobei $\Delta t$ die Zeit zwischen dem Zerstörungspuls und dem Start der Messsequenz in der Messeinrichtung zur Bestimmung des Durchflusses des Mediums und $T_1$ die Spin-Gitter-Relaxationszeit des Mediums bzw. der einzelnen Phasen des Mediums ist.

Durch eine geeignete Wahl der Länge der den Zerstörungspuls erzeugenden Antenne können Ungenauigkeiten in den Messungen reduziert und die Messungen zuverlässiger werden.

Weiter kann vorgesehen sein, dass mindestens eine weitere spulenförmig ausgebildete Antenne zur Erzeugung eines die Magnetisierung des Mediums in Richtung des Magnetfeldes zerstörenden Pulses oder einer die Magnetisierung des Mediums in Richtung des Magnetfeldes zerstörenden Pulssequenz in der Vormagnetisierungsstrecke $L_{VM}$ angeordnet ist. Hierdurch wird mindestens eine weitere effektive Vormagnetisierungsstrecke generiert. Die Antennen können direkt nebeneinander angeordnet sein. Es ist aber auch möglich, eine oder mehrere Antennen beabstandet voneinander anzuordnen. Ebenfalls denkbar ist eine Anordnung bestehend aus mindestens drei Antennen, bei denen mindestens zwei benachbart angeordnet sind und mindestens eine weitere Antenne zu den benachbart angeordneten Antennen beabstandet angeordnet ist. Jede einzelne der Antennen kann dabei die oben angeführte Bedingung für ihre Länge $L_2$ erfüllen.

Ebenfalls denkbar ist es, eine Mehrzahl von Antennen (n Antennen) direkt benachbart zueinander um das Messrohr anzuordnen, wobei jede einzelne der Antennen eine kürzere als die oben angeführte Länge aufweist. Jedoch ist dann vorgesehen, dass die Summe einer Anzahl $k \leq n$ direkt benachbarter Antennen zusammen eine Länge aufweist, die die Bedingung für $L_2$ erfüllt. Erzeugen die k Antennen gleichzeitig einen Zerstörungspuls, ist das identisch zu einer einzelnen, die Länge der Summe der Längen der k Antennen aufweisenden Antenne. Durch die Anordnung von einer Mehrzahl von Antennen, die die gleiche Länge oder verschiedene Längen haben können, ist es möglich, auf einfache Weise eine Mehrzahl von effektiven Vormagnetisierungsstrecken zu realisieren.

Aufgabe der Erfindung ist es, ein Verfahren zum Betreiben eines kernmagnetischen Durchflussmessgerätes zur Bestimmung des Durchflusses eines durch ein Messrohr strömenden Mediums anzugeben, und zwar eines mit einer aus Permanentmagneten bestehenden Magnetfelderzeugungseinrichtung zur Erzeugung eines das Medium durchsetzenden Magnetfeldes über eine Magnetfeldstrecke $L_M$, mit einer in der Magnetfeldstrecke $L_M$ liegenden Vormagnetisierungsstrecke $L_{VM}$ und mit einer eine als Messantenne dienende, spulenförmig ausgebildete Antenne der Länge $L_1$ umfassenden, ebenfalls in der Magnetfeldstrecke $L_M$ liegenden Messeinrichtung.

Das erfindungsgemäße Verfahren ist zunächst und im Wesentlichen dadurch gekennzeichnet, dass zur Bestimmung des Durchflusses das Durchflussmessgerät verwendet wird, bei dem in der Vormagnetisierungsstrecke $L_{VM}$ zumindest eine spulenförmig ausgebildete Antenne zur Erzeugung eines die Magnetisierung des Mediums in Richtung des Magnetfeldes zerstörenden Pulses oder einer die Magnetisierung in Richtung des Magnetfeldes zerstörende Pulssequenz vorgesehen ist, dass mit der spulenförmig ausgebildeten Antenne oder mit mindestens einer spulenförmig ausgebildeten Antenne in der Vormagnetisierungsstrecke ein die Magnetisierung des Mediums in Richtung des Magnetfeldes zerstörender Puls oder eine die Magnetisierung des Mediums in Richtung des Magnetfeldes zerstörende Pulssequenz erzeugt wird, dass vor der eigentlichen Messung eine Wartezeit $\Delta t$ gewartet wird und dass anschließend in der Messeinrichtung eine kernmagnetische Messung an dem magnetisierten Medium durchgeführt wird, indem das magnetisierte Medium durch Anregungssignale angeregt wird und die durch die Anregungssignale im Medium hervorgerufenen Messsignale gemessen werden.

Bei einer bevorzugten Ausführungsform des erfindungsgemäßen Verfahrens, bei dem das verwendete Durchflussmessgerät nur eine einzige spulenförmig ausgebildete Antenne zur Erzeugung eines die Magnetisierung des Mediums in Richtung des Magnetfeldes zerstörenden Pulses oder einer die Magnetisierung in Richtung des Magnetfeldes zerstörende Pulssequenz aufweist und bei dem die den Zerstörungspuls erzeugende Antenne die weiter oben aufgezeigte Bedingung für ihre Länge $L_2$ erfüllt, ist vorgesehen, dass die sich in der Vormagnetisierungsstrecke befindende Antenne einen Puls oder eine Pulsfolge erzeugt, durch den die Magnetisierung des Mediums in Richtung des Magnetfeldes, die sich in dem durch die magnetfelddurchsetzte Vormagnetisierungsstrecke strömenden Medium aufgebaut hat, zerstört wird. Zerstört wird die Magnetisierung in dem Bereich der Länge $L_3$ des Mediums, der sich zum Zeitpunkt des Pulses in dem Teil des Messrohres befindet, der von der den Zerstörungspuls erzeugenden Antenne umgeben ist. Die den Zerstörungspuls erzeugende Antenne habe die Länge $L_2$. Dann gilt $L_3 = L_2$.

Bei dem erfindungsgemäßen Verfahren kann der Zerstörungspuls ein P90-Puls, ein P180-Puls oder eine Sättigungspulssequenz sein. Das erfindungsgemäße Verfahren ist jedoch nicht auf die zuvor angesprochenen Arten von Zerstörungspulsen beschränkt. Möglich ist jeder Puls oder jede Pulssequenz, der oder die die Magnetisierung des Mediums in Richtung des Magnetfeldes zerstört.

Das erfindungsgemäße Verfahren ist, wie zuvor dargestellt, nicht auf die Anwendung bestimmter Zerstörungspulse beschränkt. Auch ist das erfindungsgemäße Verfahren nicht beschränkt auf eine bestimmte Messsequenz in der Messeinrichtung. Hier ist jede im Bereich der Durchflussmessung denkbare Sequenz möglich.

Bei einer wiederum bevorzugten Ausführungsform des erfindungsgemäßen Verfahrens, das sich insbesondere für die Durchflussmessung eines Mediums mit Pfropfenströmung eignet, ist vorgesehen, dass die Wartezeit $\Delta t$ bestimmt wird durch $\Delta t = d/v$, wobei $d$ der Abstand zwischen der den Zerstörungspuls erzeugenden Antenne und der die Messsignale aufnehmenden Antenne und $v$ die Strömungsgeschwindigkeit des Mediums ist.

Wenn die den Zerstörungspuls erzeugende Antenne die Gesetzmäßigkeit für ihre Länge erfüllt, was erfindungsgemäß vorgesehen sein kann, also eine Länge größer oder gleich der Länge der Messantenne hat, befindet sich nach der Wartezeit $\Delta t = d/v$ genau der Teil des Mediums im Bereich der Messantenne, dessen Magnetisierung vorher zerstört wurde und sich neu aufgebaut hat.

Bei einer nochmals besonderen Ausführungsform des erfindungsgemäßen Verfahrens, das sich insbesondere für die Durchflussmessung eines Mediums mit einem eine maximale Strömungsgeschwindigkeit $V_{max}$ und eine minimale Strömungsgeschwindigkeit $V_{min}$ aufweisenden Strömungsprofil eignet, ist vorgesehen, dass die Wartezeit $\Delta t$ bestimmt wird durch

$$\frac{\left(d+\dfrac{L_2}{2}-\dfrac{L_1}{2}\right)}{v_{max}} \geq \Delta t \geq \frac{\left(d-\dfrac{L_2}{2}+\dfrac{L_1}{2}\right)}{v_{min}}$$

wobei hier $L_2$ die Länge der den Zerstörungspuls erzeugenden Antenne, $L_1$ die Länge der Antenne in der Messeinrichtung, $V_{max}$ die maximale Strömungsgeschwindigkeit und $V_{min}$ die minimale Strömungsgeschwindigkeit ist. Hierdurch wird garantiert, dass der gesamte gemessene Bereich Medium enthält, dessen Magnetisierung vorher zerstört wurde.

Es hat sich gezeigt, dass beim Einhalten der zuvor dargestellten Gesetzmäßigkeiten für die Wartezeit $\Delta t$ die Beeinflussungsdauer des Magnetfeldes auf das Medium im Bereich der Vormagnetisierungsstrecke unabhängig von der Strömungsgeschwindigkeit des Mediums bzw. der einzelnen Phasen des Mediums und unabhängig vom Strömungsprofil für jede Phase ist, so dass eine einheitliche Magnetisierung jeder einzelnen Phase gewährleistet ist.

Bei dem erfindungsgemäßen Verfahren kann auch ein Durchflussmessgerät verwendet werden, bei dem mehr als eine einen die Magnetisierung des Mediums in Richtung des Magnetfeldes zerstörenden Puls oder eine die Magnetisierung des Mediums in Richtung des Magnetfeldes zerstörende Pulssequenz erzeugende Antenne in der Vormagnetisierungsstrecke $L_{VM}$ vorgesehen ist und bei dem die Antennen direkt nebeneinander oder beabstandet voneinander angeordnet sein können und jede der Antennen eine Länge $L_2$ aufweist, die die weiter oben erläuterte Gesetzmäßigkeit erfüllt. Dann kann das erfindungsgemäße Verfahren ergänzend dadurch gekennzeichnet sein, dass in einem ersten Schritt des Verfahrens eine erste Antenne einen Zerstörungspuls erzeugt, in einem zweiten Schritt eine Wartezeit $\Delta t_1$

gewartet wird, in einem dritten Schritt der Durchfluss des Mediums in der Messeinheit gemessen wird, in einem vierten Schritt eine zweite Antenne einen Zerstörungspuls erzeugt, in einem fünften Schritt wiederum eine Wartezeit $\Delta t_2$ gewartet wird und in einem sechsten Schritt der Durchfluss des Mediums in der Messeinheit gemessen wird. Sind in dem verwendeten Durchflussmessgerät mehr als zwei Zerstörungspulse erzeugende Antennen vorgesehen, werden die ersten drei Verfahrensschritte für jede weitere Antenne durchgeführt.

Wird für das erfindungsgemäße Verfahren ein Durchflussmessgerät verwendet, bei dem mehr als eine Antenne zur Erzeugung eines die Magnetisierung in Richtung des Magnetfeldes des Mediums zerstörenden Pulses oder einer die Magnetisierung des Mediums in Richtung des Magnetfeldes zerstörenden Pulssequenz vorgesehen ist, geht eine weitere Lehre dahin, dafür zu sorgen, dass mehrere Zerstörungspulse erzeugende Antennen gleichzeitig einen Zerstörungspuls erzeugen. Dabei empfiehlt es sich, nach jeder Wartezeit das Medium in der Messeinrichtung zu vermessen. Dabei verkürzt sich dann die Zeit zwischen den einzelnen Messungen auf die Differenzzeit zwischen den einzelnen Wartezeiten.

Eine konkrete Anwendung findet das erfindungsgemäße Verfahren beispielsweise bei der Bestimmung der Spin-Gitter-Relaxationszeit $T_1$:

Üblicherweise wird eine $T_1$-Messung mit einem Inversionserholungsexperiment (inverse recovery experiment) durchgeführt. Nachdem sich im Medium die volle Magnetisierung, Gleichgewichtsmagnetisierung, aufgebaut hat, wird die Magnetisierung durch einen P180-Puls invertiert, eine gewisse Zeit gewartet, in der sich die Magnetisierung wieder aufbauen kann und der Betrag der wiederhergestellten Magnetisierung für verschiedene Erholungszeiten gemessen. Der Nachteil dabei ist, dass jeweils so lange gewartet werden muss, bis die Magnetisierung wieder ihren Gleichgewichtswert erreicht hat, bevor ein neues Experiment mit einer anderen Erholungszeit durchgeführt werden kann.

Erfindungsgemäß ist nun vorgesehen, dass die Magnetisierung in dem Medium durch einen Zerstörungspuls zerstört wird, eine gewisse, aber festgelegte Zeit gewartet wird, wobei zu beachten ist, dass diese Wartezeit nicht mit der Erholungszeit verwechselt wird, in der sich ein Teil der Magnetisierung wieder aufgebaut hat und dann das Inversionserholungsexperiment, wie oben beschrieben, durchgeführt wird. Die Zeit zwischen dem Zerstörungspuls und dem Beginn des Inversionserholungsexperiments ist erfindungsgemäß kleiner als die Zeit, die es dauert, bis sich die Gleichgewichtsmagnetisierung wieder eingestellt hat. Die Gleichgewichtsmagnetisierung wird also ersetzt durch eine festgelegte "Teilmagnetisierung", wodurch die Experimente mit verschiedenen Erholungszeiten deutlich schneller hintereinander durchgeführt werden können.

Eine besonders bevorzugte Ausgestaltung des erfindungsgemäßen Verfahrens ist dadurch gekennzeichnet, dass in einem weiteren Verfahrensschritt nach der ersten kernmagnetischen Messung n weitere kernmagnetische Messungen in einem jeweiligen zeitlichen Abstand $\Delta\tau$ zueinander durchgeführt werden.

Die zuvor beschriebene Ausgestaltung eignet sich insbesondere dafür, auf sehr einfache Art und Weise die Spin-Gitter-Relaxationszeit $T_1$ des Mediums zu bestimmen. Die sich in der Vormagnetisierungsstrecke aufgebaute Magnetisierung des Mediums wird durch einen die Magnetisierung in Richtung des angelegten Magnetfeldes zerstörenden Puls oder eine die Magnetisierung in Richtung des angelegten Feldes zerstörende Pulssequenz über einen räumlichen Bereich $L_3$ zerstört.

Die Magnetisierung baut sich der oben beschriebenen Gesetzmäßigkeit folgend parallel zum äußeren angelegten Magnetfeld mit der Zeit langsam wieder auf. Nach einer ersten Zeit $\Delta t$ nach dem Zerstörungspuls hat die Magnetisierung also einen bestimmten Wert erreicht. Nach jeder weiteren Zeit $\Delta\tau$ hat sich die Magnetisierung weiter aufgebaut und weist einen jeweils ansteigenden Wert auf, so lange, bis die Gleichgewichtsmagnetisierung $M_0$ erreicht ist. Nach jeder Zeit $\Delta\tau$ wird eine kernmagnetische Messung durchgeführt und so das Medium vermessen, das "neu" in den Bereich der Messspule geströmt ist, in dem sich also insbesondere die Magnetisierung mit fortschreitender Zeit weiter aufgebaut hat. Insbesondere kann vorgesehen sein, eine FID-Messung (FID: "Free Induction Decay") durchzuführen und so die Amplitude der Magnetisierung des Mediums, das neu in den Bereich der Messspule geströmt ist, zu messen. Da der Aufbau der Magnetisierung durch die Spin-Gitter-Relaxationszeit $T_1$ bestimmt ist, lässt sich diese aus den aufgenommenen Messwerten einfach bestimmen. Diese bevorzugte Ausgestaltung weist demnach insbesondere den Vorteil auf, die Spin-Gitter-Relaxationszeit $T_1$ im Fluss bestimmen zu können.

Im Einzelnen gibt es nun verschiedene Möglichkeiten, das erfindungsgemäße Verfahren auszugestalten und weiterzubilden. Dazu wird verwiesen sowohl auf die dem Patentanspruch 1 nachgeordneten Patentansprüche als auch auf die Beschreibung bevorzugter Ausführungsbeispiele in Verbindung mit der Zeichnung. In der Zeichnung zeigt

Fig. 1     ein erstes Ausführungsbeispiel eines kernmagnetischen Durchflussmessgerätes und

Fig. 2     ein zweites Ausführungsbeispiel eines kernmagnetischen Durchflussmessgerätes.

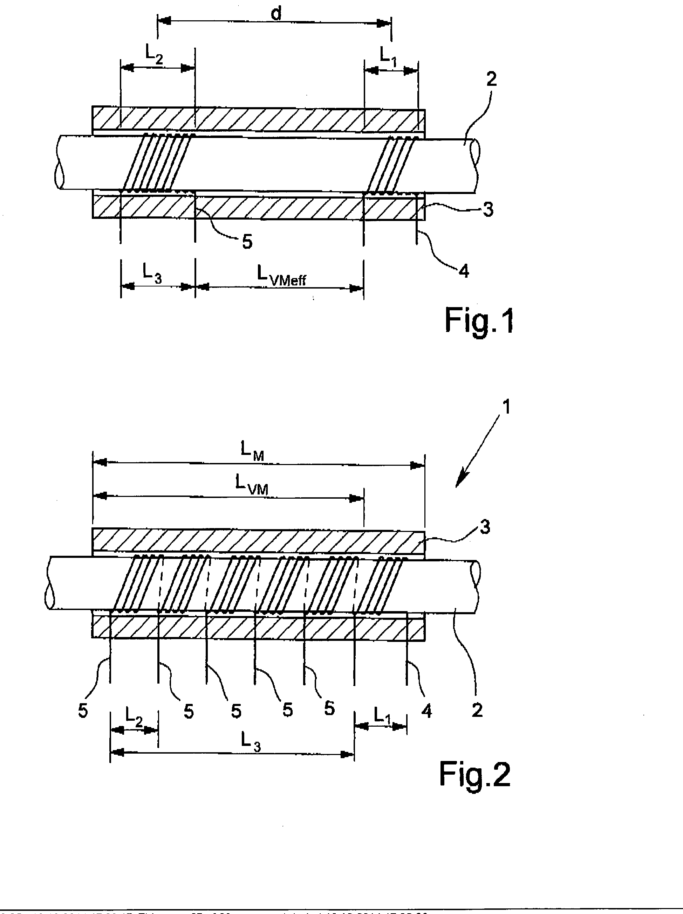

In Fig. 1 sind die wesentlichen Elemente eines ersten Ausführungsbeispiels des kernmagnetischen Durchflussmessgerätes 1 dargestellt. Das kernmagnetische Durchflussmessgerät 1 weist ein Messrohr 2 auf, durch das das Medium strömt, dessen Durchfluss bestimmt werden soll. Das Medium kann eine oder mehrere Phasen beinhalten. Zur Bestimmung des Durchflusses weist das kernmagnetische Durchflussmessgerät 1 eine Magnetfelderzeugungseinrichtung 3 auf, die um das Messrohr 2 angeordnet ist. Die Magnetfelderzeugungseinrichtung 3, die aus einem oder mehreren Permanentmagneten bestehen kann, erzeugt ein Magnetfeld, dass das Messrohr 2 über eine Magnetfeldstrecke $L_M$ durchsetzt. Am in Strömungsrichtung des Mediums gesehenen hinteren Ende der Magnetfelderzeugungseinrichtung 3 ist eine spulenförmig ausgebildete Antenne 4 vorgesehen, die sowohl zur Erzeugung von das Medium anregenden Anregungspulsen als auch zur Detektion von durch die Anregungssignale im Medium hervorgerufenen Messsignalen genutzt wird. Die spulenförmig ausgebildete Antenne 4 hat eine Länge $L_1$. Die mit dem Magnetfeld durchsetzte Strecke vor der spulenförmig ausgebildete Antenne 4 dient zur Vormagnetisierung des durch das Messrohr 2 strömenden Mediums und wird als Vormagnetisierungsstrecke $L_{VM}$ bezeichnet. In der Vormagnetisierungsstrecke $L_{VM}$ ist nun erfindungsgemäß eine spulenförmig ausgebildete Antenne 5 vorgesehen, die um das Messrohr 2 angeordnet ist. Die spulenförmig ausgebildete Antenne 5 erzeugt einen die Magnetisierung des Mediums in Richtung des durch die Magnetfelderzeugungseinrichtung 3 erzeugten Magnetfeldes zerstörenden Puls oder eine die Magnetisierung des Mediums in Richtung des erzeugten Magnetfeldes zerstörende Pulssequenz und hat eine Länge $L_2$. Die Magnetisierung des Mediums wird auf einer Strecke $L_3$ im Medium zerstört. Dargestellt in Fig. 1 ist der Fall, bei der die Strecke der zerstörten Magnetisierung $L_3$ der Länge $L_2$ der Antenne 5 entspricht.

Nachdem die Magnetisierung des Mediums zerstört worden ist, baut sie sich in dem durch die Magnetfelderzeugungseinrichtung 3 erzeugten Magnetfeld wieder auf. Dies geschieht auf einer effektiven Vormagnetisierungsstrecke $L_{VMeff}$, der Strecke zwischen der Antenne 5 und der Antenne 4. Die den Zerstörungspuls erzeugende Antenne 5 ist mit einem Abstand d von der Messantenne 4 beabstandet.

In Fig. 2 ist ein weiteres Ausführungsbeispiel des kernmagnetischen Durchflussmessgerätes dargestellt. Gleiche Elemente in den beiden Ausführungsbeispielen haben gleiche Bezugszeichen.

Der wesentliche Unterschied zwischen dem in Fig. 1 dargestellten Ausführungsbeispiel und dem in Fig. 2 dargestellten Ausführungsbeispiel besteht darin, dass im Ausführungsbeispiel nach Fig. 2 mehrere einen die Magnetisierung des Mediums zerstörenden Puls oder eine die Magnetisierung des Mediums zerstörende Pulssequenz erzeugende spulenförmig ausgebildete Antennen 5 vorgesehen sind, die um das Messrohr 2 angeordnet sind. Fig. 2 zeigt fünf solcher Antennen 5. Die Antennen 5 sind direkt nebeneinander angeordnet. Es kann jedoch auch vorgesehen sein, dass die Antennen 5 voneinander beabstandet um das Messrohr 2 angeordnet sind. Erzeugen alle Antennen gleichzeitig einen Zerstörungspuls, ist die Strecke $L_3$ der Bereich der Vormagnetisierungsstrecke, auf der die Magnetisierung des Mediums zerstört wurde.

## Patentansprüche

1. Verfahren zum Betreiben eines kernmagnetischen Durchflussmessgerätes zur Bestimmung des Durchflusses eines durch ein Messrohr strömenden Mediums, mit einer aus Permanentmagneten bestehenden Magnetfelderzeugungseinrichtung zur Erzeugung eines das Medium durchsetzenden Magnetfeldes über eine Magnetfeldstrecke $L_M$, mit einer in der Magnetfeldstrecke $L_M$ liegenden Vormagnetisierungsstrecke $L_{VM}$, und mit einer eine als Messantenne dienende, spulenförmig ausgebildete Antenne der Länge $L_1$ umfassenden, ebenfalls in der Magnetfeldstrecke $L_M$ liegenden Messeinrichtung,

    wobei zur Bestimmung des Durchflusses das Durchflussmessgerät verwendet wird, bei dem in der Vormagnetisierungsstrecke $L_{VM}$ mindestens eine spulenförmig ausgebildete Antenne zur Erzeugung eines die Magnetisierung des Mediums in Richtung des Magnetfeldes zerstörenden Pulses oder einer die Magnetisierung des Mediums in Richtung des Magnetfeldes zerstörenden Pulssequenz vorgesehen ist,
    wobei mit der spulenförmig ausgebildeten Antenne oder mit mindestens einer spulenförmig ausgebildeten Antenne in der Vormagnetisierungsstrecke ein die Magnetisierung des Mediums in Richtung des Magnetfeldes zerstörender Puls oder eine die Magnetisierung des Mediums in Richtung des Magnetfeldes zerstörende Pulssequenz erzeugt wird,
    wobei vor der eigentlichen Messung eine Wartezeit $\Delta t$ gewartet wird,
    **dadurch gekennzeichnet,**
    **dass** anschließend in der Messeinrichtung eine kernmagnetische Messung an dem magnetisierten Medium durchgeführt wird, indem das magnetisierte Medium durch Anregungssignale angeregt wird und die durch die Anregungssignale im Medium hervorgerufenen Messsignale gemessen werden.

2. Verfahren nach Anspruch 1, **dadurch gekennzeichnet, dass** der Zerstörungspuls ein P90-Puls, ein P180-Puls oder eine Sättigungspulssequenz ist.

3. Verfahren nach Anspruch 1 oder 2, wobei das durch das Messrohr strömende Medium ein Strömungsprofil mit einer

maximalen Strömungsgeschwindigkeit $V_{max}$ und einer minimalen Strömungsgeschwindigkeit $V_{min}$ aufweist, **dadurch gekennzeichnet, dass** die Wartezeit $\Delta t$ gegeben ist durch

$$\frac{\left(d + \frac{L_2}{2} - \frac{L_1}{2}\right)}{v_{max}} \geq \Delta t \geq \frac{\left(d - \frac{L_2}{2} + \frac{L_1}{2}\right)}{v_{min}}$$

wobei d der Abstand zwischen der spulenförmig ausgebildeten Antenne (5) und der Messantenne (4) ist, $L_2$ die Länge der spulenförmig ausgebildeten Antenne (5) ist und $L_1$ die Länge der Messantenne (4) ist.

4. Verfahren nach einem der Ansprüche 1 bis 3, wobei mehr als eine spulenförmig ausgebildete Antenne (5) zur Erzeugung eines die Magnetisierung des Mediums in Richtung des Magnetfeldes zerstörenden Pulses oder einer die Magnetisierung des Mediums in Richtung des Magnetfeldes zerstörenden Pulssequenz vorgesehen ist, **dadurch gekennzeichnet, dass** die spulenförmig ausgebildeten Antennen (5) zeitgleich Pulse erzeugen.

5. Verfahren nach einem der Ansprüche 1 bis 3, wobei mehr als eine spulenförmig ausgebildete Antenne (5) zur Erzeugung eines die Magnetisierung des Mediums in Richtung des Magnetfeldes zerstörenden Pulses oder einer die Magnetisierung des Mediums in Richtung des Magnetfeldes zerstörenden Pulssequenz vorgesehen ist, **dadurch gekennzeichnet, dass** die spulenförmig ausgebildeten Antennen (5) zeitlich versetzt Pulse erzeugen.

6. Verfahren nach einem der Ansprüche 1 bis 5, wobei mehr als eine spulenförmig ausgebildete Antenne (5) zur Erzeugung eines die Magnetisierung des Mediums in Richtung des Magnetfeldes zerstörenden Pulses oder einer die Magnetisierung des Mediums in Richtung des Magnetfeldes zerstörenden Pulssequenz vorgesehen ist, **dadurch gekennzeichnet, dass** benachbarte und/oder nicht benachbarte spulenförmig ausgebildete Antennen (5) die Pulse erzeugen.

7. Verfahren nach einem der Ansprüche 1 bis 4, **dadurch gekennzeichnet, dass** in einem weiteren Verfahrensschritt n weitere kernmagnetische Messungen in einem jeweiligen zeitlichen Abstand $\Delta\tau$ zueinander durchgeführt werden.

8. Verfahren nach Anspruch 7, **dadurch gekennzeichnet, dass** aus den Messwerten der n weiteren kernmagnetischen Messungen die Spin-Gitter-Relaxationszeit $T_1$ bestimmt wird.

**Claims**

1. Method for operating a nuclear magnetic flowmeter for determining the flow of a medium flowing through a measuring tube, having a magnetic field generator consisting of permanent magnets for generating a magnetic field interfusing the medium over a magnetic field section $L_M$, having a pre-magnetization section $L_{VM}$ located within the magnetic field section $L_M$ and having a measuring device also located in the magnetic field section $L_M$ including a coil-shaped antenna with the length $L_1$ serving as a measuring antenna

   wherein the flowmeter is used for determining the flow, in which at least one coil-shaped antenna is provided in the pre-magnetization section $L_{VM}$ for generating a pulse spoiling the magnetization of the medium in the direction of the magnetic field or a pulse sequence spoiling the magnetization of the medium in the direction of the magnetic field,
   wherein a pulse spoiling the magnetization of the medium in the direction of the magnetic field or a pulse sequence spoiling the magnetization of the medium in the direction of the magnetic field is generated with the coil-shaped antenna or with at least one coil-shaped antenna in the pre-magnetization section,
   wherein a waiting time $\Delta t$ is passed before the proper measurement,
   **characterized in**
   **that**, subsequently, a nuclear magnetic measurement is performed on the medium in the measuring device by exciting the magnetized medium by excitation signals and measuring the measuring signals caused by the excitation signals in the medium.

2. Method according to claim 6, **characterized in that** the spoiling pulse is a P90 pulse, a P180 pulse or a saturation pulse sequence.

3. Method according to claim 1 or 2, wherein the medium flowing through the measuring tube has a flow profile with a maximum flow velocity $v_{max}$ and a minimum flow velocity $v_{min}$, **characterized in that** the waiting time $\Delta t$ is given by

$$\frac{\left(d + \dfrac{L_2}{2} - \dfrac{L_1}{2}\right)}{v_{max}} \geq \Delta t \geq \frac{\left(d - \dfrac{L_2}{2} + \dfrac{L_1}{2}\right)}{v_{min}}$$

wherein d is the distance between the measuring antenna (4) and the coil-shaped antenna (5), $L_2$ is the length of the coil-shaped antenna (4) and $L_1$ is the length of the measuring antenna (4).

4. Method according to any one of claims 1 to 3, wherein more than one coil-shaped antenna (5) is provided for generating a pulse spoiling the magnetization of the medium in the direction of the magnetic field or a pulse sequence spoiling the magnetization of the medium in the direction of the magnetic field, **characterized in that** the coil-shaped antennae (5) simultaneously generate pulses.

5. Method according to any one of claims 1 to 3, wherein more than one coil-shaped antenna (5) is provided for generating a pulse spoiling the magnetization of the medium in the direction of the magnetic field or a pulse sequence spoiling the magnetization of the medium in the direction of the magnetic field, **characterized in that** the coil-shaped antennae (5) generate pulses staggered in time.

6. Method according to any one of claims 1 to 5, wherein more than one coil-shaped antenna (5) is provided for generating a pulse spoiling the magnetization of the medium in the direction of the magnetic field or a pulse sequence spoiling the magnetization of the medium in the direction of the magnetic field, **characterized in that** adjacent and/or non-adjacent coil-shaped antennae (5) generate the pulses.

7. Method according to any one of claims 1 to 4, **characterized in that** n further nuclear magnetic measurements are carried out with a respective time lag $\Delta\tau$ to one another in a further method step.

8. Method according to claim 7, **characterized in that** the spin-lattice-relaxation time $T_1$ is determined from the measured values of the n further nuclear magnetic measurements.

**Revendications**

1. Procédé de fonctionnement d'un débitmètre magnétique nucléaire destiné à déterminer le débit d'un milieu s'écoulant à travers un tube de mesure et comprenant un module de génération de champ magnétique muni d'aimants permanents et destiné à générer un champ magnétique à travers le milieu sur une section de champ magnétique $L_M$, une section de prémagnétisation $L_{VM}$ située dans la section de champ magnétique $L_M$, et un module de mesure qui comprend une antenne de longueur $L_1$, servant d'antenne de mesure et conçue sous la forme d'une bobine, et qui est également située dans la section de champ magnétique $L_M$,

le débitmètre étant utilisé pour déterminer le débit et le débitmètre comprenant au moins une antenne qui est conçue en forme de bobine et qui est prévue dans la section de prémagnétisation $L_{VM}$ pour générer une impulsion qui détruit la magnétisation du milieu dans la direction du champ magnétique ou une séquence d'impulsions qui détruit la magnétisation du milieu dans la direction du champ magnétique,
une impulsion qui détruit la magnétisation du milieu dans la direction du champ magnétique ou une séquence d'impulsions qui détruit la magnétisation du milieu dans la direction du champ magnétique étant générée avec l'antenne conçue en forme de bobine ou avec au moins une antenne conçue en forme de bobine dans la section de prémagnétisation,
un temps d'attente $\Delta t$ étant prévu avant la mesure proprement dite,
**caractérisé en ce que**
une mesure magnétique nucléaire est ensuite effectuée sur le milieu aimanté dans le module de mesure par excitation du milieu magnétisé à l'aide de signaux d'excitation et par mesure des signaux de mesure générés par les signaux d'excitation dans le milieu.

2. Procédé selon la revendication 1, **caractérisé en ce que** l'impulsion de destruction est une impulsion P90, une impulsion P180 ou une séquence d'impulsions de saturation.

3. Procédé selon la revendication 1 ou 2, le milieu s'écoulant à travers le tube de mesure ayant un profil d'écoulement avec une vitesse d'écoulement maximale $V_{max}$ et une vitesse d'écoulement minimale $v_{min}$, **caractérisé en ce que** le temps d'attente $\Delta t$ est donné par

$$\frac{\left(d+\frac{L_2}{2}-\frac{L_1}{2}\right)}{v_{max}} \geq \Delta t \geq \frac{\left(d-\frac{L_2}{2}+\frac{L_1}{2}\right)}{v_{min}}$$

$d$ étant la distance entre l'antenne conçue en forme de bobine (5) et l'antenne de mesure (4), $L_2$ étant la longueur de l'antenne conçue en forme de bobine (5) et $L_1$ étant la longueur de l'antenne de mesure (4).

4. Procédé selon l'une des revendications 1 à 3, plus d'une antenne conçue en forme de bobine (5) étant prévue pour générer une impulsion qui détruit la magnétisation du milieu dans la direction du champ magnétique ou une séquence d'impulsions qui détruit la magnétisation du milieu dans la direction du champ magnétique, **caractérisé en ce que** les antennes conçues en forme de bobine (5) génèrent simultanément des impulsions.

5. Procédé selon l'une des revendications 1 à 3, plus d'une antenne conçue en forme de bobine (5) étant prévue pour générer une impulsion qui détruit la magnétisation du milieu dans la direction du champ magnétique ou une séquence d'impulsions qui détruit la magnétisation du milieu dans la direction du champ magnétique, **caractérisé en ce que** les antennes conçues en forme de bobine (5) génèrent des impulsions de manière décalée dans le temps.

6. Procédé selon l'une des revendications 1 à 5, plus d'une antenne conçue en forme de bobine (5) étant prévue pour générer une impulsion qui détruit la magnétisation du milieu dans la direction du champ magnétique ou une séquence d'impulsions qui détruit la magnétisation du milieu dans la direction du champ magnétique, **caractérisé en ce que** des antennes conçues en forme de bobine (5) adjacentes et/ou non adjacentes génèrent les impulsions.

7. Procédé selon l'une des revendications 1 à 4, **caractérisé en ce que**, dans une autre étape de procédé, n autres mesures magnétiques nucléaires sont effectuées à un intervalle de temps respectif $\Delta\tau$ entre elles.

8. Procédé selon la revendication 7, **caractérisé en ce que** le temps de relaxation spin-réseau $T_1$ est déterminé à partir des valeurs de mesure des n autres mesures magnétiques nucléaires.

Fig.1

Fig.2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7872474 B2
- US 20120092007 A1